# FASCICULE DE BREVET EUROPEEN

(11) **EP 1 742 375 B1**
(45) Date de publication et mention de la délivrance du brevet: **10.09.2008**
(21) Numéro de dépôt: 06291104.5
(22) Date de dépôt: 04.07.2006
(51) Int. Cl.: H04B 1/30, H03D 3/00, H04L 27/38

(54) **Correction des défauts d'appariement entre deux voies i et q**
Korrektur von Fehlern bei der Anpassung von zwei I und Q Pfaden
Correction of adjustment errors between two I and Q paths

(30) Priorité: 06.07.2005 FR 0507215
(43) Date de publication de la demande: 10.01.2007
(73) Titulaire: STMicroelectronics SA, 92120 Montrouge (FR)
(72) Inventeur: Moutard, Arnaud, 38100 Grenoble (FR)
(74) Mandataire: Vignesoult, Serge L. M.

(56) Documents cités:
- EP-A- 1 168 597
- WO-A-20/04025826
- US-A- 6 009 317
- US-A1- 2004 156 450

## Description

L'invention concerne la correction des défauts d'appariement de signaux I et Q provenant de signaux radiodiffusés par voie de Terre.

L'invention s'applique ainsi notamment au domaine de la télévision numérique terrestre, par exemple telle que définie dans la spécification européenne DVB-T (comme « Digital Video Broadcasting-Terrestrial » en anglais), ou encore dans la spécification DVB-H (comme « Digital Video Broadcasting-Handheld » en anglais).

L'invention peut aussi s'appliquer au domaine de la radiodiffusion numérique, telle que définie par exemple dans la norme DAB (comme Digital Audio Broadcasting » en anglais).

L'invention peut également s'appliquer au domaine des réseaux locaux sans fil, tel que par exemple définis dans les normes IEEE 802.11 ou Hiperlan/2.

L'invention concerne notamment les démodulateurs et le traitement des signaux radiodiffusés reçus.

De manière générale, dans des communications à haut débit, les transmissions sont limitées entre autres par la déformation du signal au cours de la propagation. Les données peuvent être dispersées dans le temps, créant par là de l'interférence entre les symboles.

De plus, un signal radiodiffusé par voie de Terre peut être réfléchi sur un obstacle lors de la transmission. L'obstacle peut par exemple être un mur, un bâtiment ou un élément du relief. Le signal radiodiffusé peut également subir une réfraction due à l'indice d'un milieu traversé, ou encore être diffracté contre un obstacle. Par conséquent, le signal reçu par un récepteur est la combinaison d'un signal transmis sur un chemin direct depuis un émetteur et d'une multitude de signaux atténués et retardés provenant des différents chemins indirects.

La fonction de transfert d'un tel canal n'est donc pas plate en fréquence. De plus, les obstacles, l'émetteur ou le récepteur peuvent être mobiles. La fonction de transfert peut ainsi évoluer dans le temps.

Il est connu d'utiliser une modulation OFDM (comme « Orthogonal Frequency Division Multiplexing » en anglais). La transmission est assurée à l'aide d'un multiplexage fréquentiel de sous-porteuses orthogonales entre elles, séparées par un intervalle de garde. L'étape de modulation fait intervenir une transformée de Fourrier inverse et l'étape de démodulation fait intervenir une transformée de Fourrier rapide (« Fast Fourier Transform » ou FFT en anglais). La modulation OFDM permet de transmettre des signaux sur un canal radiofréquence avec une fiabilité relativement élevée.

En particulier, une modulation COFDM (comme « Coded OFDM » en anglais) peut être utilisée. La modulation COFDM permet une transmission relativement robuste aux atténuations qui peuvent affecter les sous-porteuses.

Un dispositif de réception de signaux radio comprend un syntonisateur (« tuner » en anglais). Le syntonisateur permet de replacer le signal reçu dans une bande de fréquence appropriée. Le syntonisateur peut ainsi replacer le signal reçu autour d'une fréquence intermédiaire, ou bien encore directement en bande de base. Dans ce dernier cas, le syntonisateur peut être réalisé en technologie CMOS ou BiCMOS. Le syntonisateur peut ainsi avoir une taille et une consommation relativement faibles, ce qui peut en particulier être intéressant pour des applications de type DVB-H.

Le syntonisateur transforme le signal reçu en un signal en phase noté I (comme « In phase » en anglais) et un signal en quadrature noté Q, respectivement sur une voie I et sur une voie Q. Le signal I et le signal Q sont analogiques. Il peut apparaître des défauts d'appariement entre les voies I et Q. Les défauts d'appariement comprennent les défauts en phase, c'est-à-dire que le déphasage entre les vecteurs correspondants au signal I et au signal Q n'est pas exactement de 90°. Les défauts d'appariement comprennent également les défauts en amplitude, c'est-à-dire que les vecteurs correspondants aux signaux I et Q ont des longueurs différentes.

La demande de brevet FR2853486 décrit un dispositif comprenant un syntonisateur en bande de base, des moyens de numérisation, et un bloc numérique. Outre des moyens de démodulation, le bloc numérique comprend des moyens de correction. Ces moyens de correction sont destinés à corriger les défauts d'appariement de phase et en amplitude des voies I et Q. La demande de brevet FR2853486 se réfère à des algorithmes connus pour corriger les défauts d'appariement en phase et en amplitude.

Par exemple, une erreur est mesurée et un déphasage correctif à introduire entre les signaux des voies I et Q est calculé à partir de cette erreur.

Toutefois, ces algorithmes se sont révélés peu satisfaisants quant à la correction de défauts d'appariement de signaux I et Q provenant de signaux radiodiffusés par voie de Terre.

Le document WO 2004/025826 décrit un récepteur de signaux radiofréquences.

Le document EP 1 168 597 décrit un récepteur de signaux radiofréquences.

Le document US 2004/0156450 décrit un procédé de correction des défauts d'appariement entre deux voies I et Q.

Le document US 6/009,317 décrit un procédé et un appareil pour compenser les défauts d'appariement entre signaux en quadrature.

La présente invention a pour objectif de permettre une correction des défauts d'appariement de signaux I et Q provenant de signaux radiodiffusés par voie de Terre qui soit plus satisfaisante.

L'invention a ainsi pour objet un procédé de correction de défauts d'appariement entre un signal numérique en phase et un signal numérique en quadrature provenant d'un signal radiodiffusé par voie de Terre, comprenant une méthode de correction de phase comprenant les étapes consistant à
/a/ mesurer un jeu de valeurs de première erreur pendant une première durée, dont chacune est mesurée à partir d'un symbole estimé provenant du signal radiodiffusé et du symbole théorique le plus proche du symbole estimé,
/b/ déterminer une valeur courante d'une seconde erreur à partir d'une somme des valeurs de première erreur du jeu de valeurs de première erreur,
/c/ comparer la valeur courante de la seconde erreur à une valeur antérieure de la seconde erreur conservée en mémoire,
/d/ choisir la valeur d'une correction de déphasage courante à ajouter à un déphasage antérieur introduit entre le signal numérique en phase et le signal numérique en quadrature, le choix étant effectué parmi au moins deux valeurs de correction de déphasage, à partir du résultat de la comparaison de l'étape /c/ d'une part, et de la valeur d'une correction de déphasage antérieure conservée en mémoire d'autre part,
/e/ ajouter la valeur de la correction de déphasage courante choisie à l'étape /d/ au déphasage antérieur pour obtenir un déphasage courant,
/f/ introduire le déphasage courant obtenu à l'étape /e/ entre le signal numérique en phase et le signal numérique en quadrature,
/g/ conserver en mémoire la valeur courante de la seconde erreur déterminée à l'étape /b/ et la valeur de la correction de déphasage courante choisie à l'étape /d/,
/h/ répéter les étapes précédentes.

Ainsi, selon ce procédé, la seconde erreur sert de critère de décision pour converger vers la bonne valeur de l'angle entre les voies I et Q. Le déphasage à introduire n'est pas calculé directement à partir de la valeur d'une erreur, comme dans l'art antérieur, mais appréhendé pas à pas.

Le procédé selon cet aspect de l'invention est relativement simple à mettre en oeuvre et permet une correction des défauts d'appariement entre des voies I et Q provenant de signaux radiodiffusés par voie de Terre relativement efficace.

De plus, un tel canal est susceptible d'évoluer avec le temps, de sorte qu'en répétant périodiquement les étapes du procédé, on peut obtenir une meilleure correction des défauts d'appariement de phase.

L'invention n'est limitée par l'ordre dans lequel les étapes /a/, /b/, /c/, /d/, /c/, /e/, /f/, /g/ et /h/ sont présentées que lorsque cela est nécessaire au fonctionnement de la correction de phase. Par exemple, les étapes /e/ et /g/ sont interchangeables.

Avantageusement, le procédé de correction de défauts d'appariement comprend également une méthode de correction d'amplitude.

Avantageusement, lors de l'étape /d/, le choix de la valeur de correction de déphasage courante est effectué parmi strictement deux valeurs de correction de déphasage.

La valeur courante de la seconde erreur est comparée à la valeur antérieure de la seconde erreur. Le résultat de la comparaison de l'étape /c/ peut par exemple comprendre le signe de la différence entre la valeur courante de la seconde erreur et la valeur antérieure de la seconde erreur conservée en mémoire. Cette étape de comparaison permet d'estimer si la seconde erreur a augmenté lorsque la correction de déphasage antérieure a été ajoutée, ou si au contraire la seconde erreur a diminué.

Avantageusement, les strictement deux valeurs de correction de déphasage sont de signes opposés l'un de l'autre.

Ainsi, dans le premier cas, on peut prévoir que la valeur de la correction de déphasage courante est choisie égale, ou tout au moins de même signe, que la valeur de la correction de déphasage antérieure. Dans le second cas, on peut prévoir que la valeur de la correction de déphasage courante est choisie à l'opposée, ou tout au moins de signe opposé, de la valeur de la correction de déphasage antérieure.

Alternativement, lors de l'étape /d/, le choix de la valeur de correction de déphasage courante est effectué parmi plus de deux valeurs de correction de déphasage. Cette alternative peut en particulier être envisagée pour un canal dont la fonction de transfert varie relativement peu avec le temps. Le procédé joue ainsi automatiquement sur la rapidité de convergence.

Avantageusement, la méthode de correction de phase comprend en outre une étape /i/ consistant à attendre pendant une seconde durée. Cette étape est effectuée après l'étape /e/ d'introduction du déphasage courant et avant de mesurer les valeurs de première erreur utilisées pour déterminer une prochaine valeur de la seconde erreur. Cette attente permet à un dispositif mettant en oeuvre le procédé selon cet aspect de l'invention de retrouver un régime permanent suite à l'introduction du déphasage courant. La prochaine valeur de la seconde erreur est ainsi significative de l'effet du déphasage courant.

Alternativement, la méthode de correction de phase ne comprend pas d'étape d'attente pendant une seconde durée. En effet, il est possible que le dispositif mettant en oeuvre le procédé selon cet aspect de l'invention présente une inertie relativement faible, de sorte qu'il n'est pas nécessaire d'attendre pendant la seconde durée pour obtenir des résultats significatifs.

Avantageusement, la première durée est telle que le jeu de valeurs de première erreur comprend au moins quatre valeurs de première erreur.

En effet, la fonction de transfert du canal peut être susceptible de varier avec le temps. Il peut donc être souhaitable de mesurer un certain nombre de valeurs de première erreur afin d'obtenir une valeur courante de seconde erreur significative.

Alternativement, la première durée est telle que le jeu de valeurs de première erreur comprend moins de quatre valeurs de première erreur.

La présente invention a également pour objet un dispositif de correction de défauts d'appariement entre un signal numérique en phase et un signal numérique en quadrature, respectivement sur une voie en phase et une voie en quadrature, provenant d'un signal radiodiffusé par voie de Terre et destinés à un dispositif d'estimation de symboles à partir du signal numérique en phase et du signal numérique en quadrature, le dispositif de correction comprenant un dispositif de correction de phase. Le dispositif de correction de phase comprend :
- des moyens de mémorisation de la valeur d'une correction de déphasage antérieure et de la valeur antérieure d'une seconde erreur,
- un dispositif de mesure de valeurs de première erreur entre un symbole estimé et un symbole théorique le plus proche du symbole estimé,
- des moyens de sommation permettant de déterminer la valeur courante d'une seconde erreur à partir d'une somme des valeurs de première erreur mesurées pendant une première durée,
- des premiers moyens de comparaison pour comparer la valeur courante de la seconde erreur à la valeur antérieure de la seconde erreur conservée en mémoire,
- des moyens de choix de la valeur d'une correction de déphasage courante à ajouter à un déphasage antérieur introduit entre le signal numérique en phase et le signal numérique en quadrature, le choix étant effectué parmi au moins deux valeurs de correction de déphasage, à partir du résultat de la comparaison d'une part, et de la valeur de la correction de déphasage antérieure conservée en mémoire,
- des moyens de déphasage permettant d'introduire un déphasage courant entre le signal numérique en phase et le signal numérique en quadrature, le déphasage courant étant fonction du déphasage antérieur et de la valeur de la correction de déphasage courante.
   Ce dispositif de correction de défauts d'appariement permet de mettre en oeuvre le procédé selon un des aspects de l'invention et présente donc les mêmes avantages.
   De plus, le dispositif de correction de défauts d'appariement de phase selon cet aspect de l'invention peut être intégré dans un dispositif électronique relativement facilement.
   Le dispositif électronique peut par exemple comprendre un démodulateur.
   Avantageusement, des premiers moyens de comptage commandent les moyens de sommation pour autoriser la sommation des valeurs de première erreur pendant la première durée. Cette caractéristique n'est pas limitative.
   Alternativement, les premiers moyens de comptage peuvent commander le dispositif de mesure afin que les mesures de valeurs de première erreur ne soient effectuées que pendant la première durée.
   Avantageusement, des seconds moyens de comptage commandent les moyens de sommation pour autoriser la sommation des valeurs de première erreur seulement après une seconde durée. Ainsi, après avoir introduit un nouveau déphasage, on attend que le dispositif électronique retrouve un régime établi, pour que la valeur courante de la seconde erreur soit significative.
   Alternativement, les seconds moyens de comptage commandent le dispositif de mesure.
   Cette caractéristique n'est pas non plus limitative. En particulier, le dispositif électronique peut avoir une dynamique telle qu'il n'est pas nécessaire d'attendre le temps de la seconde durée pour obtenir un critère de décision significatif.
   Avantageusement et de manière non limitative, des moyens d'estimation de canal sont situés en amont du dispositif de mesure de valeurs de première erreur. De tels moyens d'estimation de canal, par exemple un prédicteur, sont bien connus de l'homme du métier. Les premières erreurs sont ainsi mesurées entre des symboles théoriques et des symboles estimés, l'estimation des symboles comprenant une étape de correction par les moyens d'estimation de canal. En pratique, certains démodulateurs existants comprennent un dispositif de mesure d'erreur en aval d'un prédicteur. Un tel dispositif de correction de phase peut donc être inséré relativement facilement dans des démodulateurs existants.
   Le procédé selon un aspect de la présente l'invention est avantageusement utilisé lorsque le dispositif électronique selon un aspect de l'invention fonctionne en régime établi, mais cette caractéristique n'est pas limitative.
   La présente invention a également pour objet un dispositif électronique de traitement de composantes en phase et en quadrature, respectivement sur une voie en phase et une voie en quadrature, provenant de signaux radiodiffusés par voie de Terre, comprenant
- un dispositif d'estimation de symboles à partir d'un signal numérique en phase et d'un signal numérique en quadrature correspondant respectivement à la composante en phase et à la composante en quadrature, et
- un dispositif de correction de défauts d'appariement selon un aspect de la présente invention.

La présente invention a également pour objet un dispositif de réception de signaux radiodiffusés par voie de Terre comprenant :
- un syntonisateur pour replacer les signaux reçus en bande de base et délivrer une composante en phase sur une voie en phase et une composante en quadrature sur une voie en quadrature,
- un dispositif électronique selon un aspect de l'invention pour estimer des symboles à partir des composantes en phase et en quadrature.

Un tel dispositif de réception de signaux radiodiffusés peut être relativement compact.

D'autres particularités et avantages de la présente invention apparaîtront dans la description ci-après.

La figure 1 est un schéma d'un exemple de dispositif de réception de signaux radiodiffusés selon un mode de réalisation de la présente invention.

La figure 2 montre un exemple méthode de correction de la phase selon un mode de réalisation de la présente invention.

La figure 3A montre un exemple de constellation de symboles estimés sans correction de phase.

La figure 3B montre un exemple de constellation de symboles estimés avec une correction de phase selon un mode de réalisation de la présente invention de 0.5 degrés.

La figure 3C montre un exemple de constellation de symboles estimés avec une correction de phase selon un mode de réalisation de la présente invention de 2 degrés.

La figure 3D montre un exemple de constellation de symboles estimés avec une correction de phase selon un mode de réalisation de la présente invention de 2,5 degrés.

La figure 4 montre un exemple de méthode de correction d'amplitude, selon un mode de réalisation de la présente invention.

### Dispositif de réception de signaux radiodiffusés

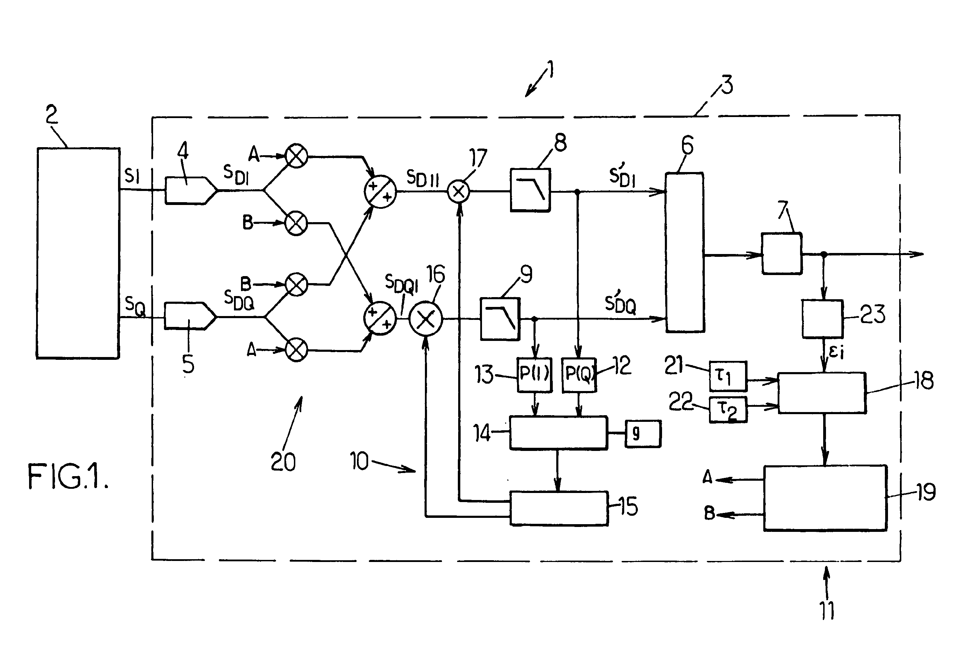

Le dispositif de réception 1 de la figure 1 comprend un syntonisateur 2 et un dispositif électronique 3. Le dispositif de réception 1 peut être réalisé en technologie mixte.

Le syntonisateur 2 permet de recevoir des signaux radiodiffusés par voie de Terre et de replacer ces signaux en bande de base. Les signaux radiodiffusés sont dans cet exemple modulés par une modulation COFDM. Le dispositif électronique 3 permet de traiter des composantes en phase S_{I} et en quadradure S_{Q} provenant des signaux replacés en bande de base.

Le dispositif électronique représenté comprend deux convertisseurs analogiques numériques (4, 5) pour numériser les composantes en phase S_{I} et en quadradure S_{Q}, créant par là un signal numérique en phase S_{DI} et un signal numérique en quadrature S_{DQ}.

Le dispositif électronique représenté 3 comprend également un dispositif d'estimation de symboles à partir du signal numérique en phase S_{DI} et du signal numérique en quadrature S_{DQ}. Le dispositif d'estimation de symboles comprend un dispositif de traitement numérique 6 et des filtres passe-bas numériques (8, 9). Ces filtres passe-bas numériques (8, 9) permettent d'assurer un filtrage relativement sélectif.

Le dispositif de traitement numérique 6 permet de démoduler un signal en phase corrigé S'_{DI} et un signal en quadrature corrigé S'_{DQ}. Le signal en phase corrigé S'_{DI} et le signal en quadrature corrigé S'_{DQ} proviennent respectivement du signal numérique en phase S_{DI} et du signal numérique en quadrature S_{DQ}.

Le dispositif de traitement numérique 6 peut comprendre un dispositif de rotation (non représenté) pour placer les signaux en bande de base avec une précision relativement élevée. Le dispositif de traitement numérique 6 peut également comprendre un filtre passe-bas (non représenté) et un dispositif de transformée de Fourier rapide (non représenté). Une mémoire (non représentée) peut indiquer le mode de modulation, par exemple QPSK (comme « Quaternary Phase Shift Keying » en anglais), 16-QAM (comme « Quadrature Amplitude Modulation » en anglais) ou encore 64-QAM.

Le dispositif de traitement numérique 6 est en soi bien connu de l'homme du métier. Le dispositif de traitement numérique 6 permet d'obtenir une constellation de symboles.

Le dispositif électronique 3 peut également comprendre un circuit de contrôle automatique de gain (non représenté) agissant sur le gain d'amplificateurs (non représenté) en amont des convertisseurs analogiques numériques (4, 5). Le circuit de contrôle automatique de gain permet de placer les amplitudes des composantes en phase et en quadrature dans une plage de valeurs telle que la conversion est optimale.

Le dispositif électronique représenté 3 comprend également des moyens d'estimation de canal, par exemple un prédicteur 7. Le prédicteur 7 permet de compenser au moins partiellement les effets du canal sur les symboles obtenus.

Le dispositif électronique représenté 3 comprend également un dispositif de correction de défauts d'appariement entre le signal numérique en phase S_{DI} et le signal numérique en quadrature S_{DQ}. Le dispositif de correction de défauts d'appariement comprend un dispositif de correction d'amplitude 10 et un dispositif de correction de phase 11.

### Dispositif et procédé de correction d'amplitude

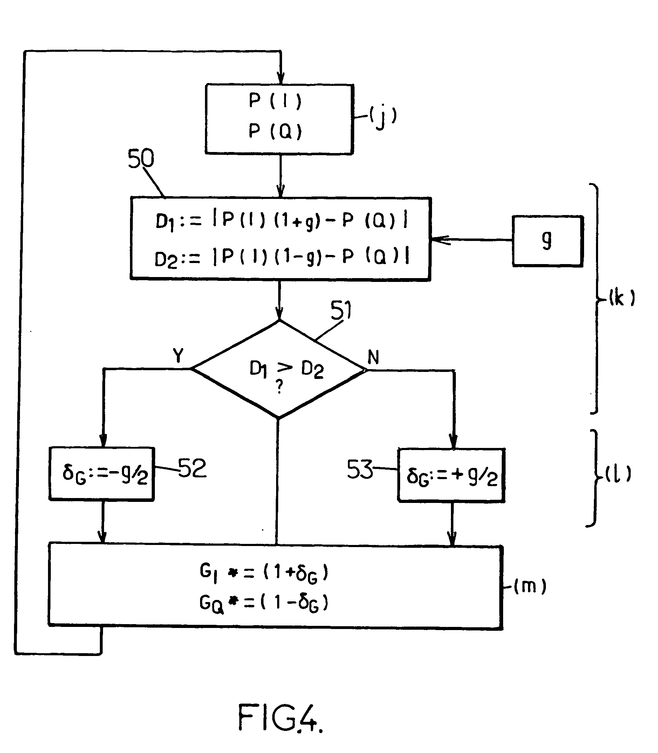

Le dispositif de correction d'amplitude 10 de la figure 1 et l'exemple de procédé de correction en amplitude de la figure 4 seront commentés simultanément.

Le dispositif de correction d'amplitude 10, comprend, dans ce mode de réalisation, deux dispositifs de calcul de puissance (12, 13), chaque dispositif de calcul de puissance permettant d'évaluer une puissance P(I) ou P(Q) sur une des voies I ou Q. Chaque puissance peut être instantanée, ou bien moyennée sur un temps donné. Pour chaque voie, une puissance est évaluée (étape (j) sur la figure 4).

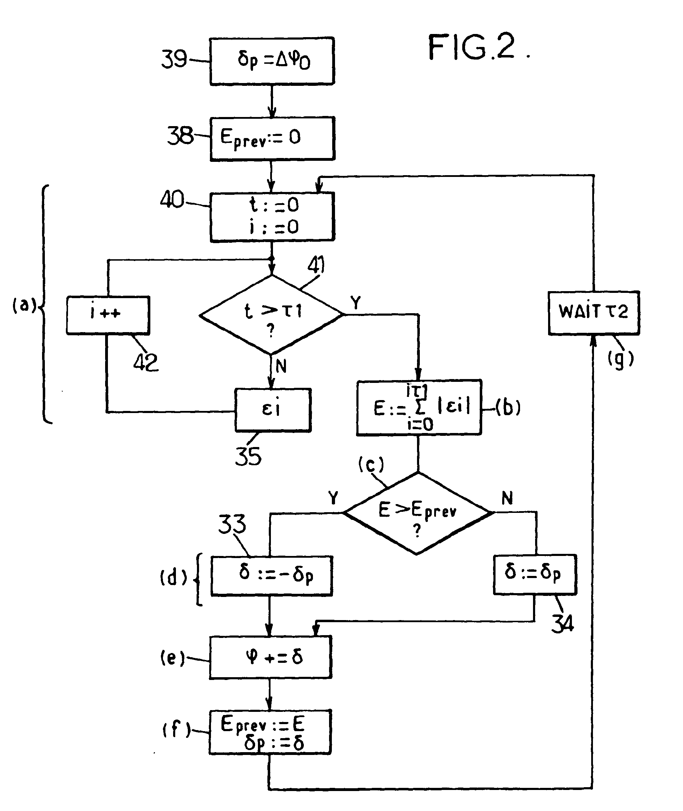

Dans l'exemple de la figure 2, les dispositifs de calcul de puissance (12, 13) utilisent un signal en phase intermédiaire S_{DII} ou un signal en quadrature intermédiaire S_{DQI} selon la voie à laquelle ils sont reliés pour estimer la puissance de cette voie. Le signal en phase intermédiaire S_{DII} et le signal en quadrature intermédiaire S_{DQI} proviennent du signal numérique en phase S_{DI} et du signal numérique en quadrature S_{DQ}.

Le dispositif de correction d'amplitude 10 comprend en outre des seconds moyens de comparaison 14 pour comparer les puissances ainsi évaluées. Cette étape, référencée (k) sur la figure 4, de comparaison des puissances évaluées à l'étape (j) peut être mise en oeuvre de multiples manières.

Par exemple, on peut avoir recours à un pas de gain g pour effectuer cette comparaison. Le pas de gain g peut être programmé. L'une des puissances évaluées, par exemple la puissance P(I) sur la voie I, est tout d'abord multipliée par un premier facteur, par exemple (1+g), avant d'être comparée à l'autre puissance, par exemple la puissance P(Q) sur la voie Q. La puissance P(I) sur la voie I est également multipliée par un second facteur, par exemple (1-g), avant d'être comparée à la puissance P(Q) sur la voie Q. Une première différence D1, égale à |P(I)(1+g) - P(Q)| et une seconde différence D2, égale à |P(I)(1-g) - P(Q)| peuvent par exemple être évaluées (étape 50 sur la figure 4). La première différence D1 est comparée à la seconde différence D2 (étape 51).

Selon un mode de réalisation alternatif et non représenté, la comparaison des puissances ne fait pas intervenir de pas de gain. On peut par exemple comparer directement les puissances P(I) et P(Q) entre elles.

Pour revenir à la figure 1, un résultat de la comparaison, par exemple la valeur d'une variable booléenne, est transmis à des moyens de répartition des gains 15 reliés aux seconds moyens de comparaison 14.

Les moyens de répartition des gains 15 permettent de choisir une valeur de correction de gain δ_{G} parmi au moins deux valeurs de corrections de gain (étape (I) sur la figure 4).

Avantageusement et de manière non limitative, la valeur de la correction de gain δ_{G} est choisie parmi strictement deux valeurs. Avantageusement et de manière non limitative, les strictement deux valeurs de correction de gain potentielles ont des signes opposés. Avantageusement, ces deux valeurs sont sensiblement égales en valeur absolue, comme par exemple les valeurs (-g/2, +g/2).

Si la première différence D1 est plus faible que la seconde différence D2, on peut considérer que la puissance dans la voie I est trop faible et la valeur de la correction de gain choisie δ_{G} est alors +g/2 (étape 53 sur la figure 4).

Si la première différence D1 est plus élevée que la seconde différence D2, on peut considérer que la puissance dans la voie I est trop élevée et la valeur de la correction de gain choisie δ_{G} est alors -g/2 (étape 52 sur la figure 4).

Le dispositif de correction d'amplitude 10 de la figure 2 comprend en outre deux multiplieurs (16, 17). Chaque multiplieur (16, 17) est situé sur une des voies en amont du dispositif de calcul de puissance (12, 13) correspondant. Chaque multiplieur permet d'appliquer un gain correspondant à la voie sur laquelle il est situé.

Pour chacune des voies, le gain courant à appliquer à cette voie peut être déterminé à partir d'un gain antérieur appliqué à cette voie d'une part, et de valeur de la correction de gain choisie δ_{G} (étape (m) sur la figure 4). Le gain d'un multiplieur 17 de la voie en phase est par exemple multiplié par un facteur d'environ (1+ δ_{G}). Le gain d'un multiplieur 16 de la voie en quadrature est par exemple multiplié par un facteur d'environ (1- δ_{G}). Le gain de chaque multiplieur est déterminé par les moyens de répartition des gains 15.

Selon un mode de réalisation alternatif et non représenté, le gain courant à appliquer à une voie n'est déterminé que pour une des voies. Le gain courant est déterminé à partir d'un gain antérieur appliqué à cette voie d'une part, et de la valeur de correction de gain d'autre part. Par exemple, seul le gain du multiplieur 17 de la voie en phase est multiplié par un facteur (1+2 *δ_{G}).

Les dispositifs de calcul de puissance (12, 13), les seconds moyens de comparaison 14, et les moyens de répartition des gains 15 peuvent fonctionner en continu. Les étapes (j), (k), (l), (m) et l'étape d'application du gain courant sont ainsi répétées. Les défauts d'appariement en amplitude sont ainsi corrigés pas à pas.

Dans cet exemple, les valeurs potentielles de la correction de gain (-g/2 ; +g/2) dérivent de la valeur du pas de gain g, mais il peut en être disposé autrement.

La valeur absolue de la correction de gain peut par exemple correspondre à un gain de 0,17dB.

On peut également prévoir que plusieurs valeurs absolues de corrections de gain sont possibles, par exemple g/2 et 2g. Ainsi, plusieurs modes peuvent être envisagés : par exemple un mode lent dans lequel on converge relativement lentement vers une correction des défauts d'appariement en amplitude et un mode rapide dans lequel la convergence est plus rapide. En mode lent, le gain du multiplieur 17 de la voie en phase peut seulement être multiplié par un facteur (1+g/2) ou (1-g/2). En mode rapide, le gain du multiplieur 17 de la voie en phase peut seulement être multiplié par un facteur (1+2g) ou (1-2g). Le mode lent peut par exemple être adopté lorsque le dispositif électronique 3 fonctionne en régime permanent. Le mode rapide peut par exemple être adopté lorsque le dispositif électronique 3 est en régime transitoire.

D'autres dispositifs de correction d'amplitude que celui représenté peuvent être utilisés.

### Dispositif de correction de phase

Le dispositif électronique 3 de la figure 1 comprend en outre un dispositif de correction de phase.

Le dispositif de correction de phase 11 comprend un dispositif de mesure 23 de valeurs de première erreur ∈ᵢ situé en aval du prédicteur 7. Les premières erreurs ∈ᵢ sont mesurées entre un symbole estimé par le dispositif de traitement numérique 6 et par le prédicteur 7, et un symbole théorique le plus proche du symbole estimé. La première erreur peut comprendre la distance entre le point correspondant au symbole estimé et le point correspondant au symbole théorique sur une constellation.

Des moyens de sommation 18 permettent de déterminer la valeur courante d'une seconde erreur à partir d'une somme des valeurs des premières erreurs mesurées ∈ᵢ pendant une première durée *T*₁. La valeur courante de la seconde erreur peut par exemple être une somme, éventuellement pondérée, des premières erreurs mesurées ∈ᵢ, ou bien encore une moyenne.

Par ailleurs, le dispositif de correction de phase 11 comprend des moyens de mémorisation (non représentés), par exemple une mémoire, pour conserver la valeur de valeur antérieure de la seconde erreur et d'une correction de déphasage antérieure.

Des premiers moyens de comparaison, ici confondus avec les moyens de sommation 18, permettent de comparer la valeur courante de la seconde erreur à la valeur antérieure de la seconde erreur. Des moyens de choix, ici confondus avec les moyens de sommation 18, permettent de choisir la valeur d'une correction de déphasage courante parmi deux valeurs de correction de déphasage. Le choix est effectué à partir d'un résultat de la comparaison d'une part, et de la valeur de la correction de déphasage antérieure conservée en mémoire d'autre part.

Les moyens de sommation 18, les premiers moyens de comparaison et les moyens de choix peuvent être intégrés dans un seul processeur.

Des moyens de déphasage (19, 20) permettent d'introduire un déphasage courant entre le signal numérique en phase et le signal numérique en quadrature. Le déphasage courant est fonction de la valeur de la correction de déphasage courante et d'un déphasage antérieur. Le déphasage courant est choisi égal au déphasage antérieur additionné de la correction de déphasage choisie. Le déphasage augmente ou diminue selon le signe de la correction de déphasage choisie.

Les moyens de déphasage peuvent comprendre un circuit de récupération de phase 20 et une table 19. La table 19 permet de fournir une première valeur A et une seconde valeur B à partir du déphasage désiré. Cette première valeur A et cette seconde valeur B sont injectées dans le circuit de récupération de phase 20. Pour une valeur de déphasage de φ, la première valeur peut être sensiblement égale à cos(φ/2)/(2*cos (φ)) et la seconde valeur peut être sensiblement égale à sin(φ/2)/(2*cos (φ)). En pratique, on peut prévoir que le déphasage reste dans une certaine plage, par exemple [-8° ; +8°]. Le déphasage étant susceptible de varier de façon discrète, avec des corrections de déphasage par exemple de -1° ° ou +1° seulement, la table 19 comprend un tableau de taille relativement raisonnable.

Les corrections de déphasage peuvent également avoir des valeurs absolues plus élevées ou plus faibles, par exemple 0,1 degrés.

Ce dispositif de correction de phase permet de converger vers une valeur de déphasage adéquate.

Les moyens de sommation 18 sont ici commandés par des premiers moyens de comptage 21 et par des seconds moyens de comptage 22.

Les premiers moyens de comptage n'autorisent la sommation des premières erreurs mesurées ∈ᵢ que pendant la première durée *T*₁. Cette sommation sur une pluralité de valeurs de première erreur permet de d'absorber au moins partiellement des variations du canal au cours du temps.

Les seconds moyens de comptage 22 n'autorisent la sommation qu'une fois passé un certain laps de temps correspondant à une seconde durée *T*₂. Ce laps de temps peut permettre au dispositif électronique 3 de retrouver un régime permanent après la modification du déphasage apportée. Une nouvelle valeur de la seconde erreur n'est donc établie que passé cette seconde durée *T*₂.

La première durée peut par exemple être de 1 ms, ou encore de 8 s. La seconde durée peut également avoir des valeurs diverses, par exemple 10 ms.

Dans cet exemple, la correction en phase est effectuée avant la correction en amplitude. Il peut bien entendu en être autrement.

### Procédé de correction des défauts d'appariement de phase

La figure 2 montre un exemple d'algorithme de correction de défauts d'appariement selon mode de réalisation de l'invention.

Ce procédé comprend une étape (b) de détermination de la valeur courante d'une seconde erreur E. La valeur courante de cette seconde erreur E est comparée à la valeur antérieure de la seconde erreur Eₚᵣₑᵥ (étape (c)). La valeur d'une correction de déphasage courante δ est choisie (étape (d)) parmi deux valeurs de correction de déphasage (-δₚ ,+δₚ) selon le résultat de la comparaison et selon la valeur d'une correction de déphasage antérieure δₚ. La valeur de la correction de déphasage courante δ choisie est ajoutée à un déphasage antérieur φ (étape (e)), pour obtenir la valeur d'un déphasage courant. Ce déphasage courant est introduit entre un signal numérique en phase et un signal numérique en quadrature, par exemple avec une table et un circuit de récupération de phase.

Ces étapes sont destinées à être répétées régulièrement. L'algorithme peut prévoir une attente (étape (g)) pendant une seconde durée *T*₂ entre deux cycles d'exécution, cette seconde durée *T*₂ pouvant éventuellement être nulle ou modifiée.

Lors d'un premier cycle, l'algorithme peut prévoir des étapes d'initiation (39, 38).

La valeur de la correction de phase antérieure δₚ est ainsi initialisée (étape 39) à une certaine valeur Δϕ₀. Dans l'exemple représenté, cette certaine valeur Δϕ₀ correspond au pas de déphasage désiré. Plus Δϕ₀ est élevé, plus la convergence est rapide.

De la même façon, la valeur antérieure de la seconde erreur Eₚᵣₑᵥ est initialisée (étape 38), par exemple à zéro. Alternativement, cette première valeur antérieure de la seconde erreur est mesurée avant l'exécution du premier cycle.

Le premier cycle comprend une étape (a) de mesure d'un jeu de valeurs de première erreur ∈ᵢ pendant une première durée *T*₁.

Dans cet exemple, les mesures (étape 35) n'ont lieu que pendant la première durée *T*₁. L'étape (a) comprend à cet effet une boucle sur un indice i, avec des étapes d'initiation de la boucle 40, de test 41 et d'incrémentation 42.

Alternativement, des premières erreurs sont mesurées en permanence et le jeu de valeurs de première erreur ∈ᵢ ne comprend que les valeurs de première erreur ∈ᵢ mesurées pendant la première durée *T*₁, comme dans le dispositif de la figure 1.

Les valeurs de première erreur ∈ᵢ du jeu de valeurs de première erreur sont sommées (étape (b)) afin de déterminer la valeur courante de la seconde erreur E. Dans cet exemple, on somme les valeurs absolues des premières erreurs ∈ᵢ.

Cette valeur courante de la seconde erreur E est comparée à la valeur antérieure de la seconde erreur Eₚᵣₑᵥ (étape (c)). Lors du premier cycle, avec une valeur antérieure de la seconde erreur Eₚᵣₑᵥ nulle, l'algorithme représenté conduit à choisir (étape 33) l'opposé de la valeur de la correction de déphasage antérieure δₚ comme valeur de correction de déphasage courante δ, soit -Δϕ₀. Le pas de déphasage Δϕ₀ est donc soustrait au déphasage courant φ (étape (e)).

Avant l'exécution de l'étape (e), le déphasage courant φ peut avoir une valeur arbitrairement choisie. Cette valeur peut être nulle.

Après l'exécution de l'étape (e), le déphasage est introduit entre les voies I et Q.

La valeur courante de la seconde erreur E est conservée en tant que valeur antérieure de la seconde erreur Eₚᵣₑᵥ et la valeur de la correction de déphasage courante δ est conservée en tant que correction de déphasage antérieure δₚ (étape (f)).

Après l'exécution de l'étape (g) d'attente pendant la seconde durée *T*₂, un nouveau cycle peut recommencer.

Par « courant », on se rapporte au cycle en cours, tandis que par « antérieur », on se rapporte à un cycle précédent, ou à une initialisation.

Lors de ce nouveau cycle, la valeur antérieure de la seconde erreur Eₚᵣₑᵥ est comparée à la valeur courante de la seconde erreur E, mesurée lors du nouveau cycle.

Si la valeur courante de la seconde erreur E est plus élevée que la valeur antérieure de la seconde erreur Eₚᵣₑᵥ, mesurée lors du premier cycle, on estime que la correction de déphasage introduite n'a pas participé à compenser le déphasage réel entre les signaux des voies I et Q. On estime au contraire que la correction de déphasage introduite a aggravé le déphasage réel entre les signaux des voies I et Q. En conséquence, la valeur de la correction de déphasage courante δ est choisie égale à l'opposé de la correction de déphasage antérieure δₚ (étape 33).

Alternativement, on peut prévoir qu'à l'étape 33, la valeur de la correction de déphasage courante δ est choisie égale au double de l'opposé de la correction de déphasage antérieure δₚ. On évite ainsi de perdre un cycle pour revenir à une situation de statu quo.

Si la valeur courante de la seconde erreur E est plus faible que la valeur antérieure de la seconde erreur Eₚᵣₑᵥ, mesurée lors du premier cycle, on estime que le pas de déphasage introduit a participé à compenser le déphasage réel entre les signaux des voies I et Q. En conséquence, la valeur de la correction de déphasage courante δ est choisie égale à la correction de déphasage antérieure δₚ (étape 34).

En répétant ces cycles périodiquement, on converge vers une valeur de déphasage proche du déphasage réel entre les voies I et Q.

### Exemple de correction de phase

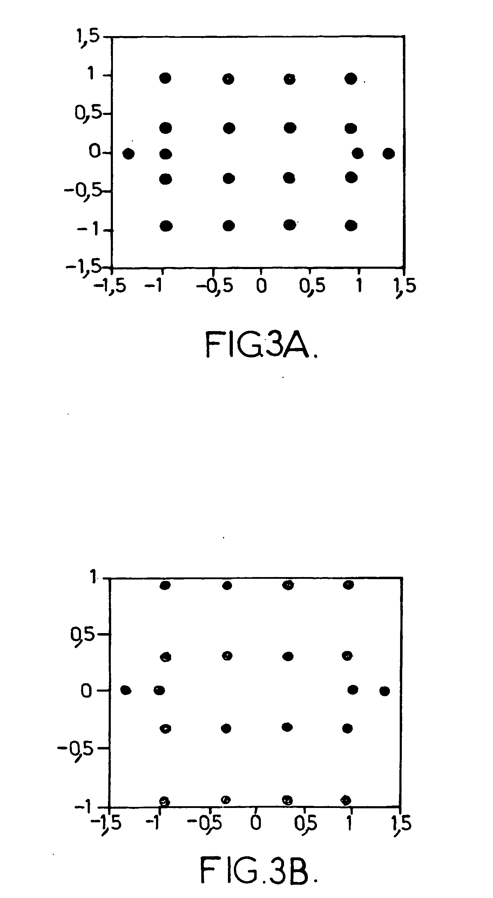

La figure 3A montre un exemple de constellation de symboles estimés sans correction de phase. Le déphasage réel entre les voies I et Q est de 2,2 degrés. On peut observer un ensemble de taches : les symboles estimés sont seulement proches des symboles théoriques.

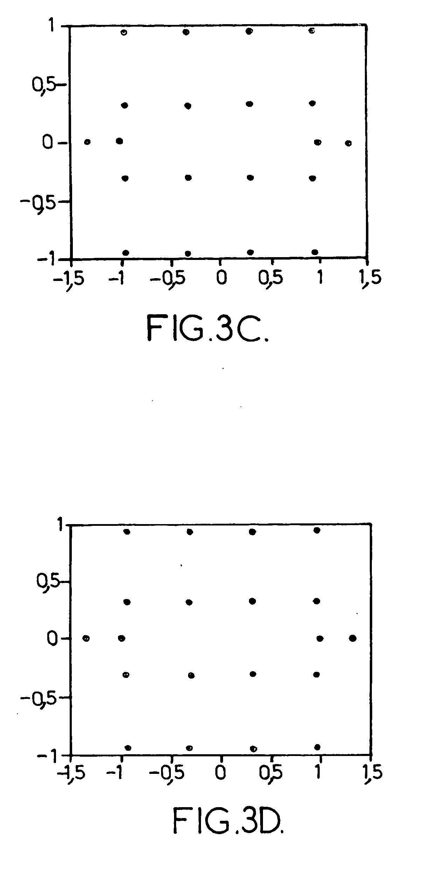

Lorsqu'on applique à de tels signaux un algorithme de correction de phase comme celui de la figure 2, on peut améliorer cet état de chose, comme le montrent les constellations des figures 3B, 3C et 3D.

On choisit un déphasage initial nul, et un pas de déphasage de 0,5 degrés. Après l'exécution d'un premier cycle, un déphasage de +0,5 degrés a été introduit entre les voies I et Q. Comme le montre la constellation de la figure 3B, les taches sont plus petites que les taches de la figure 3A.

Aussi, lors de l'exécution d'un second cycle, il est jugé que le déphasage de +0,5 degrés améliore la correction des défauts d'appariement entre les voies I et Q. Une nouvelle correction de déphasage de 0,5 degrés est introduite, soit un déphasage de 1 degré.

D'autres cycles sont exécutés et le déphasage introduit se rapproche du déphasage réel. Comme le montrent les figures 3C et 3D, les taches sont sensiblement similaires pour un déphasage introduit de 2 degrés (figure 3C) et pour un déphasage introduit de 2,5 degrés (figure 3D).

Lorsque ces valeurs sont atteintes, les symboles estimés sont relativement proches des symboles théoriques.

### Variantes

Avec un algorithme tel que celui de la figure 2, le déphasage introduit va osciller autour du déphasage réel.

On peut prévoir d'augmenter la valeur de la seconde durée lorsqu'un certain nombre de cycles ont été exécutés. En effet, on peut estimer qu'après un certain nombre de cycles, la valeur du déphasage introduit est relativement proche de la valeur du déphasage réel. Les cycles peuvent donc être exécutés de façon plus épisodique, à des fins de surveillance.

On peut également prévoir une valeur du pas de déphasage Δϕ₀ relativement élevée lors de l'exécution des premiers cycles, puis plus faible. En effet, le déphasage réel peut être relativement différent de la valeur de déphasage choisie arbitrairement, de sorte qu'un pas de déphasage relativement élevé permet de converger plus rapidement vers la valeur du déphasage réel.

## Revendications

1. Procédé de correction de défauts d'appariement entre un signal numérique en phase et un signal numérique en quadrature, respectivement sur une voie en phase et une voie en quadrature, provenant d'un signal radiodiffusé par voie de Terre, comprenant une méthode de correction de phase comprenant les étapes consistant à
/a/ mesurer un jeu de valeurs de première erreur pendant une première durée, dont chacune est mesurée à partir d'un symbole estimé provenant du signal radiodiffusé et du symbole théorique le plus proche du symbole estimé,
/b/ déterminer une valeur courante d'une seconde erreur à partir d'une somme des valeurs de première erreur du jeu de valeurs de première erreur,
/c/ comparer la valeur courante de la seconde erreur à une valeur antérieure de la seconde erreur conservée en mémoire,
/d/ choisir la valeur d'une correction de déphasage courante à ajouter à un déphasage antérieur introduit entre le signal numérique en phase et le signal numérique en quadrature, le choix étant effectué parmi au moins deux valeurs de correction de déphasage, à partir du résultat de la comparaison de l'étape /c/ d'une part, et de la valeur d'une correction de déphasage antérieure conservée en mémoire d'autre part,
/e/ ajouter la valeur de la correction de déphasage courante choisie à l'étape /d/ au déphasage antérieur pour obtenir un déphasage courant,
/f/ introduire le déphasage courant obtenu à l'étape /e/ entre le signal numérique en phase et le signal numérique en quadrature,
/g/ conserver en mémoire la valeur courante de la seconde erreur déterminée à l'étape /b/ et la valeur de la correction de déphasage courante choisie à l'étape /d/,
/h/ répéter les étapes précédentes.

2. Procédé selon la revendication 1, dans lequel
lors de l'étape /d/, le choix de la valeur de correction de déphasage courante est effectué parmi strictement deux valeurs de correction de déphasage, de signes opposés l'un de l'autre.

3. Procédé selon l'une des revendications précédentes, dans lequel la méthode de correction de phase comprend en outre l'étape consistant à
/i/ attendre pendant une seconde durée.

4. Procédé selon l'une des revendications précédentes, dans lequel
la première durée est telle que le jeu de valeurs de première erreur comprend au moins quatre valeurs de première erreur.

5. Procédé selon l'une des revendications précédentes, comprenant en outre une méthode de correction d'amplitude, comprenant les étapes consistant à
/j/ évaluer une puissance pour chaque voie,
/k/ comparer les puissances évaluées à l'étape /j/,
/l/ choisir une valeur de correction de gain parmi au moins deux valeurs de correction de gain, à partir d'un résultat de la comparaison,
/m/ pour au moins une des voies, déterminer le gain courant à appliquer à cette voie, à partir d'un gain antérieur appliqué à cette voie d'une part, et de la valeur de correction de gain choisie d'autre part,
/n/ pour chaque voie pour laquelle un gain courant a été déterminé à l'étape /m/, appliquer ce gain courant à cette voie, et
/o/ répéter les étapes /j/, /k/, /l/, /m/ et /n/.

6. Dispositif de correction de défauts d'appariement entre un signal numérique en phase (S_{DI}) et un signal numérique en quadrature (S_{DQ}), respectivement sur une voie en phase et une voie en quadrature, provenant d'un signal radiodiffusé par voie de Terre et destinés à un dispositif d'estimation de symboles à partir du signal numérique en phase (S_{DI}) et du signal numérique en quadrature (S_{DQ}), le dispositif de correction comprenant un dispositif de correction de phase (11),
**caractérisé en ce que** le dispositif de correction de phase comprend
des moyens de mémorisation de la valeur d'une correction de déphasage antérieure (δₚ) et de la valeur antérieure d'une seconde erreur (Eₚᵣₑᵥ),
un dispositif de mesure (23) de valeurs de première erreur (∈ᵢ) entre un symbole estimé et un symbole théorique le plus proche du symbole estimé,
des moyens de sommation (18) permettant de déterminer la valeur courante de la seconde erreur (E) à partir d'une somme des valeurs de première erreur mesurées pendant une première durée (*T*₁),
des premiers moyens de comparaison (18) pour comparer la valeur courante de la seconde erreur à la valeur antérieure de la seconde erreur conservée en mémoire,
des moyens de choix (18) de la valeur d'une correction de déphasage courante (δ) à ajouter à un déphasage antérieur (φ) introduit entre le signal numérique en phase et le signal numérique en quadrature, le choix étant effectué parmi au moins deux valeurs de correction de déphasage, à partir du résultat de la comparaison d'une part, et de la valeur de la correction de déphasage antérieure conservée en mémoire,
des moyens de déphasage (19, 20) permettant d'introduire un déphasage courant entre le signal numérique en phase et le signal numérique en quadrature, le déphasage courant étant fonction du déphasage antérieur et de la valeur de la correction de déphasage courante.

7. Dispositif de correction de défauts d'appariement selon la revendication 6, dans lequel le dispositif de correction de phase comprend en outre
des premiers moyens de comptage (21) commandant les moyens de sommation (18) pour autoriser la sommation des valeurs de première erreur (∈ᵢ) pendant la première durée (*T*₁).

8. Dispositif de correction de défauts d'appariement selon l'une des revendications 6 à 7, dans lequel le dispositif de correction de phase comprend en outre
des seconds moyens de comptage (22) commandant les moyens de sommation (18) pour autoriser la sommation des valeurs de première erreur (∈ᵢ) seulement après une seconde durée (*T*₂).

9. Dispositif de correction de défauts d'appariement selon l'une des revendications 6 à 8, comprenant en outre
des moyens d'estimation de canal (7) situés en amont du dispositif (23) de mesure de valeurs de première erreur (∈ᵢ).

10. Dispositif de correction de défauts d'appariement selon l'une des revendications 6 à 9, comprenant en outre un dispositif de correction d'amplitude (10) comprenant
deux dispositifs de calcul de puissance (12, 13), chaque dispositif de calcul de puissance permettant d'évaluer une puissance sur une des voies,
des seconds moyens de comparaison (14) pour comparer les puissances évaluées par les dispositifs de calcul de puissance,
des moyens de répartition des gains (15) reliés aux seconds moyens de comparaison, pour choisir une valeur de correction de gain parmi au moins deux valeurs de correction de gain, et
deux multiplieurs (16, 17) , chaque multiplieur étant situé sur une des voies en amont du dispositif de calcul de puissance correspondant, le gain de chaque multiplieur étant déterminé par les moyens de répartition des gains à partir d'un gain antérieur correspondant à ce multiplieur et de la valeur de correction de gain choisie.

11. Dispositif électronique (3) de traitement de composantes en phase (S_{I}) et en quadrature (S_{Q}), respectivement sur une voie en phase et une voie en quadrature, provenant de signaux radiodiffusés par voie de Terre, comprenant
un dispositif d'estimation de symboles à partir d'un signal numérique en phase (S_{DI}) et d'un signal numérique en quadrature (S_{DQ}) correspondant respectivement à la composante en phase et à la composante en quadrature, et
un dispositif de correction de défauts d'appariement selon l'une des revendications 6 à 10.

12. Dispositif de réception (1) de signaux radiodiffusés par voie de Terre comprenant
un syntonisateur (2) pour replacer les signaux reçus en bande de base et délivrer une composante en phase (S_{I}) sur une voie en phase et une composante en quadrature (S_{Q}) sur une voie en quadrature,
un dispositif électronique (3) selon la revendication 11 pour estimer des symboles à partir des composantes en phase et en quadrature.

13. Dispositif de réception (1) de signaux radiodiffusés selon la revendication 12, **caractérisé en ce que** le dispositif de réception est réalisé en technologie mixte.

## Claims

1. A method for correcting mismatches between a digital signal in phase and a digital signal in quadrature, respectively on a channel in phase and a channel in quadrature, originating from a signal broadcast by terrestrial channel, comprising a phase correction method comprising
/a/ measuring a set of first error values during a first period, each value being measured based on an estimated symbol originating from the broadcast signal and the theoretical symbol nearest to the estimated symbol,
/b/ determining a current value of a second error based on a sum of the first error values of the set of first error values,
/c/ comparing the current second error value with a previous second error value stored in memory,
/d/ choosing the value of a current phase shift correction to be added to a previous phase shift introduced between the digital signal in phase and the digital signal in quadrature, the choice being made from at least two phase shift correction values, based on the result of the comparison of the step /c/ on the one hand, and the value of a previous phase shift correction stored in memory on the other hand,
/e/ adding the current phase shift correction value chosen in the step /d/ to the previous phase shift to obtain a current phase shift,
/f/ introducing the current phase shift obtained in the step /e/ between the digital signal in phase and the digital signal in quadrature,
/g/ storing in memory the current second error value determined in the step /b/ and the current phase shift correction value chosen in the step /d/,
/h/ repeating the above steps.

2. The method of Claim 1, wherein
in the step /d/, the choice of the current phase shift correction value is made from strictly two phase shift correction values, of signs opposite to each other.

3. The method of one of the preceding claims, wherein the phase correction method also comprises
/i/ waiting for a second period.

4. The method of one of the preceding claims, wherein
the first period is such that the set of first error values comprises at least four first error values.

5. A method of one of the preceding claims, also comprising an amplitude correction method, comprising
/j/ assessing a power for each channel,
/k/ comparing the powers assessed in the step /j/,
/l/ choosing a gain correction value from at least two gain correction values, based on a comparison result,
/m/ for at least one of the channels, determining the current gain to be applied to this channel, based on a previous gain applied to this channel on the one hand, and the gain correction value chosen on the other hand,
/n/ for each channel for which a current gain has been determined in the step /m/, applying said current gain to said channel, and
/o/ repeating the steps /j/, /k/, /l/, /m/ and /n/.

6. A device for correcting mismatches between a digital signal in phase (S_{DI}) and a digital signal in quadrature (S_{DQ}), respectively on a channel in phase and a channel in quadrature, originating from a signal broadcast by terrestrial channel and intended for a device for estimating symbols based on the digital signal in phase (S_{DI}) and the digital signal in quadrature (S_{DQ}), the correction device including a phase correction device (11),
**characterized in that** the phase correction device comprises
storing means for storing the value of a previous phase shift correction (δₚ) and the previous value of a second error (Eₚᵣₑᵥ),
a measuring device (23) for measuring first error values (εᵢ) between an estimated symbol and a theoretical symbol nearest to the estimated symbol,
summing means (18) for determining the current value of the second error (E) based on a sum of the first error values measured during a first period (_{T1}),
first comparison means (18) for comparing the current second error value with the previous second error value stored in memory,
choosing means (18) for choosing the value of a current phase shift correction (δ) to be added to a previous phase shift (ϕ) introduced between the digital signal in phase and the digital signal in quadrature, the choice being made from at least two phase shift correction values, based on the result of the comparison on the one hand, and on the previous phase shift correction value stored in memory,
phase shifting means (19, 20) for introducing a current phase shift between the digital signal in phase and the digital signal in quadrature, the current phase shift being dependent on the previous phase shift and the current phase shift correction value.

7. The device for correcting mismatches of Claim 6, wherein the phase correction device further comprises
first counting means (21) controlling the summing means (18) to enable the summing of the first error values (εᵢ) during the first period (T₁).

8. The device for correcting mismatches of one of Claims 6 to 7, wherein the phase correction device further comprises
second counting means (22) controlling the summing means (18) to enable the summing of the first error values (εᵢ) only after a second period (T₂).

9. The device for correcting mismatches of one of Claims 6 to 8, further comprising
channel estimation means (7) located upstream from the device (23) for measuring first error values (εᵢ).

10. The device for correcting mismatches of one of Claims 6 to 9, further comprising an amplitude correction device (10) comprising
two power calculation devices (12, 13), each power calculation device allowing to assess a power on one of the channels,
second comparison means (14) for comparing the powers assessed by the power calculation devices,
gain distribution means (15) linked to the second comparison means, for choosing a gain correction value from at least two gain correction values, and
two multipliers (16, 17), each multiplier being located on one of the channels upstream from the corresponding power calculation device, the gain of each multiplier being determined by the gain distribution means based on a previous gain corresponding to this multiplier and on the chosen gain correction value.

11. An electronic device (3) for processing components in phase (S_{I}) and in quadrature (S_{Q}), respectively on a channel in phase and a channel in quadrature, originating from signals broadcast by terrestrial channel, including
a device for estimating symbols based on a digital signal in phase (S_{DI}) and a digital signal in quadrature (S_{DQ}) respectively corresponding to the component in phase and the component in quadrature, and
a device for correcting mismatches according to one of Claims 6 to 10.

12. A device (1) for receiving signals broadcast by terrestrial channel including
a tuner (2) for replacing the signals received in baseband and outputting a component in phase (S_{I}) on a channel in phase and a component in quadrature (S_{Q}) on a channel in quadrature,
an electronic device (3) according to Claim 11 for estimating symbols based on the components in phase and in quadrature.

13. The device (1) for receiving broadcast signals of Claim 12, **characterized in that** the reception device is implemented in hybrid technology.

## Patentansprüche

1. Verfahren zur Korrektur von Fehlern bei der Anpassung zwischen einem Digitalsignal in Phase und einem Digitalsignal in Quadratur auf einem Pfad in Phase beziehungsweise einem Pfad in Quadratur, die von einem terrestrisch per Funk gesendeten Signal stammen, das ein Phasenkorrekturverfahren umfasst, das die folgenden Schritte umfasst:
/a/ Messen einer Gruppe von ersten Fehlerwerten während einer ersten Dauer, von denen jeder ausgehend von einem geschätzten Symbol, das vom per Funk gesendeten Signal stammt, und dem theoretischen Symbol, das am nächsten am geschätzten Symbol liegt, gemessen wird,
/b/ Bestimmen eines aktuellen Werts eines zweiten Fehlers ausgehend von einer Summe der ersten Fehlerwerte der Gruppe von ersten Fehlerwerten,
/c/ Vergleichen des aktuellen Werts des zweiten Fehlers mit einem abgespeicherten vorherigen Wert des zweiten Fehlers,
/d/ Wählen des Werts einer aktuellen, einer vorherigen zwischen dem Digitalsignal in Phase und dem Digitalsignal in Quadratur eingeführten Phasenverschiebung hinzuzufügenden Phasenverschiebungskorrektur, wobei die Wahl unter mindestens zwei Phasenverschiebungs-Korrekturwerten ausgehend vom Ergebnis des Vergleichs von Schritt /c/ einerseits und dem Wert einer abgespeicherten vorherigen Phasenverschiebungskorrektur andererseits getroffen wird,
/e/ Hinzufügen des in Schritt /d/ gewählten aktuellen Phasenverschiebungs-Korrekturwerts zur vorherigen Phasenverschiebung zum Erhalten einer aktuellen Phasenverschiebung,
/f/ Einführen der in Schritt /e/ erhaltenen aktuellen Phasenverschiebung zwischen dem Digitalsignal in Phase und dem Digitalsignal in Quadratur,
/g/ Abspeichern des in Schritt /b/ bestimmten aktuellen Werts des zweiten Fehlers und des in Schritt /d/ gewählten aktuellen Phasenverschiebungs-Korrekturwerts,
/h/ Wiederholen der vorhergehenden Schritte.

2. Verfahren nach Anspruch 1, wobei:
während des Schritts /d/ die Wahl des aktuellen Phasenverschiebungs-Korrekturwerts unter genau zwei Phasenverschiebungs-Korrekturwerten mit voneinander entgegengesetzten Vorzeichen durchgeführt wird.

3. Verfahren nach einem der vorhergehenden Ansprüche, wobei das Phasenkorrekturverfahren ferner den folgenden Schritt umfasst:
/i/ Warten während einer zweiten Dauer.

4. Verfahren nach einem der vorhergehenden Ansprüche, wobei:
die erste Dauer derart ist, dass die Gruppe von ersten Fehlerwerten mindestens vier erste Fehlerwerte umfasst.

5. Verfahren nach einem der vorhergehenden Ansprüche, das ferner ein Amplitudenkorrekturverfahren umfasst, das die folgenden Schritte umfasst:
/j/ Bewerten einer Leistung für jeden Pfad,
/k/ Vergleichen der in Schritt /j/ bewerteten Leistungen,
/l/ Wählen eines Verstärkungskorrekturwerts unter mindestens zwei Verstärkungskorrekturwerten ausgehend von einem Ergebnis des Vergleichs,
/m/ Bestimmen der aktuellen, an diesen Pfad anzulegenden Verstärkung für mindestens einen der Pfade ausgehend von einer vorherigen an diesen Pfad angelegten Verstärkung einerseits und dem gewählten Verstärkungskorrekturwert andererseits,
/n/ für jeden Pfad, für den in Schritt /m/ eine aktuelle Verstärkung bestimmt wurde, Anlegen dieser aktuellen Verstärkung an diesen Pfad, und
/o/ wiederholen der Schritte /j/, /k/, /l/, /m/ und /n/.

6. Vorrichtung zur Korrektur von Fehlern bei der Anpassung zwischen einem Digitalsignal in Phase (S_{DI}) und einem Digitalsignal in Quadratur (S_{DQ}) auf einem Pfad in Phase beziehungsweise einem Pfad in Quadratur, die von einem terrestrisch per Funk gesendeten Signal stammen und die für eine Vorrichtung zum Schätzen von Symbolen ausgehend vom Digitalsignal in Phase (S_{DI}) und dem Digitalsignal in Quadratur (S_{DQ}) bestimmt sind, wobei die Korrekturvorrichtung eine Phasenkorrekturvorrichtung (11) umfasst,
**dadurch gekennzeichnet, dass** die Phasenkorrekturvorrichtung Folgendes umfasst:
Mittel zum Speichern des Werts einer vorherigen Phasenverschiebungskorrektur (δₚ) und des vorherigen Werts eines zweiten Fehlers (Eₚᵣₑᵥ) ,
eine Vorrichtung zum Messen (23) von ersten Fehlerwerten (εᵢ) zwischen einem geschätzten Symbol und einem am nächsten am geschätzten Symbol gelegenen theoretischen Symbol,
Summierungsmittel (18), die das Bestimmen des aktuellen Werts des zweiten Fehlers (E) ausgehend von einer Summe der während einer ersten Dauer (T₁) gemessenen ersten Fehlerwerte ermöglichen,
erste Vergleichsmittel (18) zum Vergleichen des aktuellen Werts des zweiten Fehlers mit dem abgespeicherten vorherigen Wert des zweiten Fehlers,
Mittel zur Wahl (18) des Werts einer aktuellen, einer vorherigen zwischen dem Digitalsignal in Phase und dem Digitalsignal in Quadratur eingeführten Phasenverschiebung (φ) hinzuzufügenden Phasenverschiebungskorrektur (δ), wobei die Wahl unter mindestens zwei Phasenverschiebungs-Korrekturwerten ausgehend vom Ergebnis des Vergleichs einerseits und dem abgespeicherten vorherigen Wert der Phasenverschiebungskorrektur getroffen wird,
Phasenverschiebungsmittel (19, 20), die das Einführen einer aktuellen Phasenverschiebung zwischen dem Digitalsignal in Phase und dem Digitalsignal in Quadratur ermöglichen, wobei die aktuelle Phasenverschiebung eine Funktion der vorherigen Phasenverschiebung und des aktuellen Phasenverschiebungs-Korrekturwerts ist.

7. Vorrichtung zur Korrektur von Anpassungsfehlern nach Anspruch 6, wobei die Phasenkorrekturvorrichtung ferner Folgendes umfasst:
erste Zählmittel (21), die die Summierungsmittel (18) steuern, um die Summierung der ersten Fehlerwerte (εᵢ) während der ersten Dauer (T₁) zu erlauben.

8. Vorrichtung zur Korrektur von Anpassungsfehlern nach einem der Ansprüche 6 bis 7, wobei die Phasenkorrekturvorrichtung ferner Folgendes umfasst:
zweite Zählmittel (22), die die Summierungsmittel (18) steuern, um die Summierung der ersten Fehlerwerte (εᵢ) nur nach einer zweiten Dauer (T₂) zu erlauben.

9. Vorrichtung zur Korrektur von Anpassungsfehlern nach einem der Ansprüche 6 bis 8, die ferner Folgendes umfasst:
Kanalschätzungsmittel (7), die der Vorrichtung (23) zum Messen von ersten Fehlerwerten (εᵢ) vorgelagert angeordnet sind.

10. Vorrichtung zur Korrektur von Anpassungsfehlern nach einem der Ansprüche 6 bis 9, die ferner eine Amplitudenkorrekturvorrichtung (10) umfasst, die Folgendes umfasst:
zwei Leistungsberechnungsvorrichtungen (12, 13), wobei jede Leistungsberechnungsvorrichtung die Bewertung einer Leistung auf einem der Pfade ermöglicht,
zweite Vergleichsmittel (14) zum Vergleichen der durch die Leistungsberechnungsvorrichtungen bewerteten Leistungen,
mit den zweiten Vergleichsmitteln verbundene Mittel zur Verteilung der Verstärkungen (15) zum Wählen eines Verstärkungskorrekturwerts unter mindestens zwei Verstärkungskorrekturwerten, und
zwei Multiplikatoren (16, 17), wobei sich jeder Multiplikator der entsprechenden Leistungsberechnungsvorrichtung vorgelagert auf einem der Pfade befindet, wobei die Verstärkung jedes Multiplikators durch Mittel zur Verteilung der Verstärkungen ausgehend von einer vorherigen Verstärkung, die diesem Multiplikator entspricht, und dem gewählten Verstärkungskorrekturwert bestimmt wird.

11. Elektronische Vorrichtung (3) zur Verarbeitung von Komponenten in Phase (S_{I}) und in Quadratur (S_{Q}) auf einem Pfad in Phase beziehungsweise einem Pfad in Quadratur, die von terrestrisch per Funk gesendeten Signalen stammen, die Folgendes umfasst:
eine Vorrichtung zum Schätzen von Symbolen ausgehend von einem Digitalsignal in Phase (S_{DI}) und einem Digitalsignal in Quadratur (S_{DQ}), die der Komponente in Phase beziehungsweise der Komponente in Quadratur entsprechen, und
eine Vorrichtung zur Korrektur von Anpassungsfehlern nach einem der Ansprüche 6 bis 10.

12. Vorrichtung zum Empfang (1) von terrestrisch per Funk gesendeten Signalen, die Folgendes umfasst:
ein Abstimmgerät (2) zum Zurücksetzen der empfangenen Signale in das Basisband und Liefern einer Komponente in Phase (S_{I}) auf einem Pfad in Phase und einer Komponente in Quadratur (S_{Q}) auf einem Pfad in Quadratur,
eine elektronische Vorrichtung (3) nach Anspruch 11 zum Schätzen der Symbole ausgehend von den Komponenten in Phase und in Quadratur.

13. Vorrichtung zum Empfang (1) von per Funk gesendeten Signalen nach Anspruch 12, **dadurch gekennzeichnet, dass** die Empfangsvorrichtung in gemischter Technologie ausgeführt ist.
